# EUROPÄISCHE PATENTANMELDUNG

(11) **EP 0 784 340 A1**
(43) Veröffentlichungstag der Anmeldung: **16.07.1997**
(21) Anmeldenummer: 97100389.2
(22) Anmeldetag: 11.01.1997
(51) Int. Cl.: H01L 21/336, H01L 29/417, H01L 29/78

(54) **Verfahren zum Kontaktieren von Bereichen mit verschiedener Dotierung in einem Halbleiterbauelement und Halbleiterbauelement**

(30) Priorität: 11.01.1996 DE 19600780
(71) Anmelder: Deutsche ITT Industries GmbH, 79108 Freiburg (DE)
(72) Erfinder: Igel, Günter, Dipl.-Ing., 79312 Emmendingen (DE)

(57) **Zusammenfassung**

Die Erfindung betrifft ein Verfahren zum Kontaktieren von Bereichen mit verschiedener Dotierung in einem Halbleiterbauelement, welche in einem Siliziumsubstrat 1 in unterschiedlicher Tiefe angeordnet sind, wobei der erste Bereich 3 mit einer ersten Dotierung und der kleineren Tiefe im zweiten Bereich 2 mit der zweiten Dotierung und der größeren Tiefe angeordnet ist, und auf den ersten Bereich 3 eine erste Metallschicht 6 aufgebracht wird. Auf einem Teilbereich der ersten Metallschicht 6 wird eine zweite Metallschicht 8 aufgebracht, und die Anordnung wird einer Wärmebehandlung unterzogen, bei der der erste Bereich 3 mit der ersten Metallschicht 6 und der zweite Bereich 2 über die erste Metallschicht 6 mit der zweiten Metallschicht 8 kontaktiert wird.

## Beschreibung

Die Erfindung betrifft ein Verfahren zum Kontaktieren von Bereichen mit verschiedener Dotierung in einem Halbleiterbauelement, welche in einem Siliziumsubstrat in unterschiedlicher Tiefe angeordnet sind, wobei der erste Bereich mit einer ersten Dotierung und der kleineren Tiefe in dem zweiten Bereich mit einer zweiten Dotierung und der größeren Tiefe angeordnet ist, und auf den ersten Bereich eine erste Metallschicht aufgebracht wird.

Ferner betrifft die Erfindung ein Halbleiterbauelement mit einem Siliziumsubstrat, in dem ein erster Bereich einer ersten Tiefe mit einer ersten Dotierung und ein zweiter Bereich einer zweiten, größeren Tiefe mit einer zweiten Dotierung ausgebildet sind, wobei auf dem ersten Bereich eine erste Metallschicht aufgebracht ist.

Ein derartiges Verfahren und eine derartige Vorrichtung sind aus der Praxis bekannt. Durch eine Wärmebehandlung kann der Kontakt zwischen dem ersten Bereich und der ersten Metallschicht hergestellt werden. Um den zweiten, tiefer liegenden Bereich zu kontaktieren, wird beispielsweise in den ersten Bereich ein zusätzlicher Bereich eingebracht, der mit dem zweiten Bereich verbunden ist und den gleichen Dotierungstyp wie der zweite Bereich aufweist. So kann bei der Wärmebehandlung auch der zweite Bereich mit der ersten Metallschicht kontaktiert werden. Dieses Verfahren wird beispielsweise bei der Herstellung von DMOS-Transistoren angewandt. In diesem Fall ist das Halbleitersubstrat schwach n-dotiert, der zweite Bereich schwach p-dotiert und der erste Bereich stark n-dotiert. Um einen zuverlässigen, niederohmigen Kontakt zu dem schwach p-dotierten, zweiten Bereich herzustellen, ist der in den ersten Bereich eingebrachte Anschlußbereich stark p-dotiert. Das Einbringen dieses stark p-dotierten Bereiches erfordert einen zusätzlichen Maskenschritt, bei dem es sehr wesentlich auf eine genaue Justierung ankommt; denn die Lage des zusätzlichen Bereiches bestimmt die Cröße der verbleibenden Teile des ersten Bereiches und damit auch die Eigenschaften der durch diesen und den zweiten Bereich gebildeten Diode. Somit ist das Aufbringen des zusätzlichen Bereiches zum Kontaktieren des zweiten Bereiches eine sehr kritische Größe.

Der Erfindung liegt die Aufgabe zugrunde, das gattungsgemäße Verfahren und die gattungsgemäße Vorrichtung derart weiter zu bilden, daß die Kontaktierung der dotierten Bereiche unterschiedlicher Tiefe einfacher erfolgen kann.

Diese Aufgabe wird durch ein gattungsgemäße Verfahren gelöst, bei dem auf einen Teilbereich der ersten Metallschicht eine zweite Metallschicht aufgebracht wird, und die Anordnung einer Wärmebehandlung unterzogen wird, bei der der erste Bereich mit der ersten Metallschicht und der zweite Bereich über die erste Metallschicht mit der zweiten Metallschicht kontaktiert wird.

Ferner wird die Erfindung durch ein gattungsgemäßes Halbleiterbauelement gelöst, bei dem auf einem Teilbereich der ersten Metallschicht eine zweite Metallschicht aufgebracht ist, und der Teilbereich der ersten Metallschicht mit der zweiten Metallschicht aufgrund einer Wärmebehandlung derart durch den ersten Bereich in den zweiten Bereich abgesenkt ist, daß über die erste und zweite Metallschicht ein Kontaktanschluß zu dem zweiten Bereich und über einen nicht mit der zweiten Metallschicht bedeckten Teilbereich der ersten Metallschicht ein Kontaktanschluß zu dem ersten Bereich gebildet ist.

Bei der Wärmebehandlung erfolgt eine Diffusion der Siliziumatome aus dem Siliziumsubstrat, insbesondere dem ersten Bereich durch die erste Metallschicht in die zweite Metallschicht. Hierdurch senken sich im Bereich der zweiten Metallschicht die erste und die zweite Metallschicht ab, d.h. in das Siliziumsubstrat hinein. Zu einer Kontaktierung des zweiten Bereichs muß diese Absenkung so lange erfolgen, bis die erste Metallschicht einen Kontakt mit dem zweiten Bereich bildet. Durch die Wärmebehandlung entsteht somit ein Kontakt zwischen dem zweiten Bereich und der ersten Metallschicht und der zweiten Metallschicht mit der ersten Metallschicht. Dieses Verfahren hat den Vorteil, daß das Aufbringen der zweiten Metallschicht unkritisch ist, da durch Toleranzen in der Justierung keine Parameter beeinflußt werden, die für die Funktion des Halbleiterbauelements erforderlich sind.

Es ist vorteilhaft, wenn der zweite Bereich eine Dotierung kleiner Konzentration aufweist.

Dann entsteht bei der Kontaktierung mit der ersten und zweiten Metallschicht eine Schottky-Diode, die gute Flußeigenschaften hat, so daß der Kontaktwiderstand nicht stört. Auch ist es günstig, wenn die Dotierung des ersten Bereichs von zu dem zweiten Bereich entgegengesetztem Dotierungstyp ist. So entsteht parallel zu der Schottky-Diode eine weitere Diode mit einem pn-Übergang. Der erste Bereich kann eine Dotierung hoher Konzentration aufweisen, wodurch ein niederohmiger Kontakt bei der Kontaktierung mit der ersten Metallschicht erzielt wird. Sind alle obengenannten Voraussetzungen erfüllt und ist zusätzlich das Substrat vom ersten Dotierungstyp mit niedriger Konzentration und ist ferner oberhalb des zweiten Dotierungsbereich eine von diesem isolierten Gate-Elektrode angeordnet, so bildet die Anordnung einen DMOS-Transistor. Ein Bereich mit niedriger Konzentration kann beispielsweise 10¹⁵ Atome/cm³ und ein hochdotierter Bereich 10¹⁸ Atome/cm³ enthalten. Die genaue Wahl der Dotierung ist jedoch davon abhängig, welche Art von Halbleiterbauelement hergestellt werden soll.

Auch ist es vorteilhaft, wenn die Wärmebehandlung bei einer Temperatur von wenigstens 600° C durchgeführt wird. Dabei wird innerhalb eines nicht zu großen Zeitintervalls eine gute Kontaktierung des ersten Bereichs und des zweiten Bereichs mit der ersten bzw. zweiten Metallschicht erreicht. Günstigerweise kann die erste Metallschicht aus einem anderen Material als die zweite Metallschicht bestehen. Dann kann die erste Metallschicht so gewählt sein, daß sie eine große Diffusionsgeschwindigkeit für Siliziumatome, und die zweite Metallschicht kann so gewählt sein, daß sie eine große Löslichkeit für Siliziumatome aufweist. Durch eine deratige Metallauswahl wird eine schnelle und effektive Absenkung der Metallschichten und eine zuverlässige Kontaktbildung erzielt. Günstige Metalle sind Paladium für die erste Metallschicht und Titan für die zweite Metallschicht. Auch kann Prozeßzeit bei der Herstellung des Halbleiterbauelements gespart werden, wenn die Wärmebehandlung gleichzeitig mit einer entsprechenden Wärmebehandlung eines anderen Verfahrensschrittes bei der Herstellung des Halbleiterbauelements durchgeführt wird. Hierzu ist insbesondere die Wärmebehandlung der Rückseitenmetallisierung des Bauelements geeignet, da diese bei einer Temperatur durchgeführt wird, bei der auch die Kontaktbildung besonders gut funktioniert.

Im folgenden wird die Erfindung anhand der Zeichnung näher erläutert.

Es zeigen:
Fig. 1 einen Querschnitt durch ein Halbleiterbauelement, das nach dem erfindungsgemäßen Verfahren hergestellt wird, vor der Wärmebehandlung und
Fig. 2 das Halbleiterbauelement der Fig. 1 nach der Wärmebehandlung.

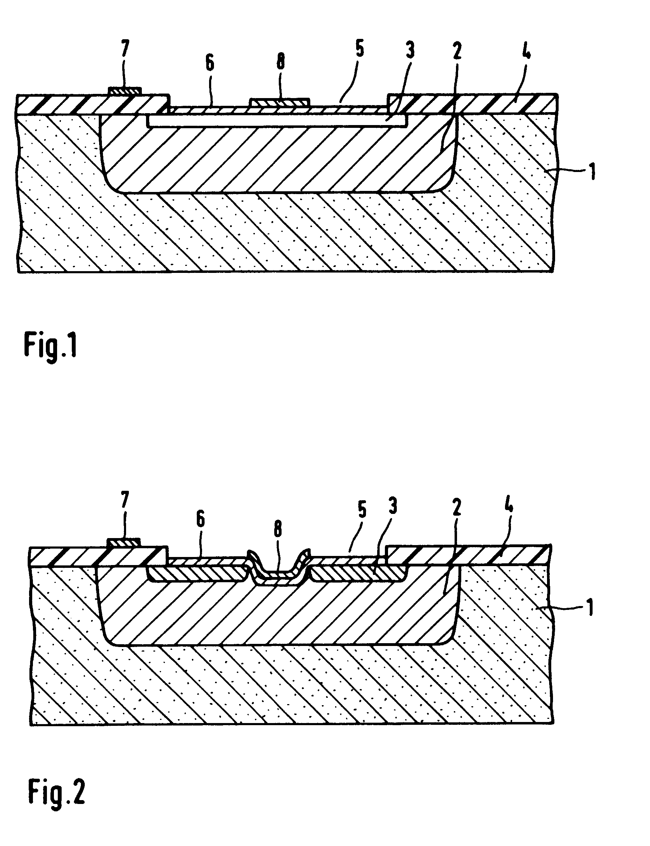

In der Figur wird die Erfindung anhand eines DMOS-Transistors erläutert. Es können aber auch andere Halbleiterbauelemente mit Bereichen verschiedener Dotierung und unterschiedlicher Tiefe in einem Siliziumsubstrat entsprechend kontaktiert werden. Fig. 1 zeigt einen Querschnitt durch einen DMOS-Transistor vor der Wärmebehandlung. Der DMOS-Transistor weißt ein Siliziumsubstrat 1 auf. Es wird hier davon ausgegangen, daß das Siliziumsubstrat 1 schwach n-dotiert ist, woraus sich die folgenden beschriebenen Dotierung für dieses Ausführungsbeispiel ergeben. Das Substrat 1 enthält einen zweiten Bereich 2, der schwach p-dotiert ist. In dem zweiten Bereich ist ein erster Bereich 3 einer kleineren Tiefe ausgebildet, der stark n-dotiert ist. Auf der Oberfläche des Siliziumsubstrats 1 ist eine Maskierungsschicht 4 aufgebracht, die in einem Teilbereich des ersten Bereichs 3 eine Öffnung 5 aufweist. Innerhalb der Öffnung 5 der Maskierungsschicht 4 ist eine erste Metallschicht 6 aufgebracht. Ferner ist auf der Maskierungsschicht 4 oberhalb des zweiten Bereichs 2 eine Gate-Elektrode 7 aufgebracht. Auf einem Teilbereich der ersten Metallschicht 6 ist eine zweite Metallschicht 8 aufgebracht.

Fig. 2 zeigt das gleiche Halbleiterbauelement, einen DMOS-Transistor, nach dem die Anordnung der Fig. 1 einer Wärmebehandlung unterzogen worden ist. Bei der Wärmebehandlung haben sich die erste Metallschicht 6 und die zweite Metallschicht 8 in dem Bereich der zweiten Metallschicht 8 so weit in den Halbleiterkörper abgesenkt, daß sie durch den ersten Bereich 3 hindurch in den zweiten Bereich 2 gelangt sind. Dort ist ein Kontakt zwischen dem zweiten Bereich und der ersten Metallschicht entstanden, welche wiederum mit der zweiten Metallschicht 8 kontaktiert ist. Gleichzeitig wurde bei der Wärmebehandlung der erste Bereich 3 mit der ersten Metallschicht 6 in dem nicht mit der zweiten Metallschicht 8 überdeckten Bereich kontaktiert.

Somit ist ein DMCE-Transistor entstanden, bei dem das Siliziumsubstrat 1 den Drain-Bereich darstellt, der erste Bereich 3 den Source-Bereich und der zweite Bereich 3 den Kanalbereich, dessen Wirkungsweise von der Gate-Elektrode 7 gesteuert wird. Der Kontakt zwischen der ersten Metallschicht 6, der zweiten Metallschicht 8 und dem zweiten Bereich 2 bildet eine Schottky-Diode, die gute Flußeigenschaften hat, so daß an dieser Stelle der Kontaktwiderstand zwischen Metall und Halbleiter keine Rolle spielt. Ein bevorzugtes Material für die erste Metallschicht 6 ist Paladium, für die zweite Metallschicht 8 Titan.

Im folgenden wird das Verfahren zum Kontaktieren anhand des in der Figur gezeigten DMOS-Bauelements erläutert. Bis zur Erzeugung des ersten Bereiches 3 und des zweiten Bereiches 2 in dem Siliziumsubstrat 1 entspricht das Herstellungsverfahren dem im Stand der Technik üblichen Herstellungsverfahren für ein DMOS-Bauelement. Dann wird eine Maske 4 mit einer Öffnung 5 auf den ersten Bereich 3 aufgebracht. Die erste Metallschicht 6 wird auf den ersten Bereich 3 in der Öffnung 5 der Maskierungsschicht 4 abgeschieden. Ebenfalls wird eine Gate-Elektrode 7 auf die Maskierungsschicht 4 aufgebracht. Mit einem weiteren Maskierungsverfahren wird auf einen Teilbereich der ersten Metallschicht 6 eine zweite Metallschicht 8 aufgebracht. Die Maskierungsverfahren erfolgen mit den dem Fachmann bekannten Techniken, wie Photolithographie und Ätzverfahren. Dann wird das Halbleiterbauelement einer Wärmebehandlung bei einer vorgegebenen Temperatur für eine bestimmte Zeit ausgesetzt. Die Temperatur beträgt dabei vorzugsweise 600° C oder mehr. Die Zeit wird vorherbestimmt und kann durch einen anderen Verfahrensprozeß festgelegt sein. Bei der Wärmebehandlung wandern Siliziumatome, insbesondere aus dem ersten Bereich 3 durch die erste Metallschicht 6 in die zweite Metallschicht 8. Die erste Metallschicht 6 ist dabei vorzugsweise so gewählt, daß sie eine große Diffusionsgeschwindigkeit für Siliziumatome aufweist. Die zweite Metallschicht 8 ist dabei vorzugsweise so gewählt, daß sie eine große Löslichkeit für Siliziumatome aufweist, so daß diese darin aufgenommen werden können. Da die Siliziumatome aus dem ersten Bereich 3 verschwinden, senken sich an dieser Stelle die erste Metallschicht 6 und die zweite Metallschicht 8 ab, um dieses Volumen aufzufüllen. Die Wärmebehandlung wird dann beendet, wenn die erste Metallschicht 6 im zweiten Bereich 2 angekommen ist und an dieser Stelle alle Siliziumatome des ersten Bereiches 3 in der zweiten Metallschicht 8 aufgenommen worden sind. An dieser Stelle entsteht ein Kontakt zwischen der ersten Metallschicht 6 und dem zweiten Bereich 2. Während der Wärmebehandlung ist ebenfalls ein Kontakt zwischen der ersten Metallschicht 6 und dem ersten Bereich 3 entstanden.

## Patentansprüche

1. Verfahren zum Kontaktieren von Bereichen mit verschiedener Dotierung in einem Halbleiterbauelement, welche in einem Siliziumsubstrat (1) in unterschiedlicher Tiefe angeordnet sind, wobei der erste Bereich (3) mit einer ersten Dotierung und der kleineren Tiefe in dem zweiten Bereich (2) mit einer zweiten Dotierung und der größeren Tiefe angeordnet ist, und auf den ersten Bereich (3) eine erste Metallschicht (6) aufgebracht wird, dadurch gekennzeichnet, daß auf einen Teilbereich der ersten Metallschicht (6) eine zweite Metallschicht (8) aufgebracht wird, und die Anordnung einer Wärmebehandlung unterzogen wird, bei der der erste Bereich (3) mit der ersten Metallschicht (6) und der zweite Bereich (2) über die erste Metallschicht (6) mit der zweiten Metallschicht (8) kontaktiert wird.

2. Verfahren nach Anspruch 1, dadurch gekennzeichnet, daß der zweite Bereich (2) eine Dotierung kleiner Konzentration aufweist.

3. Verfahren nach Anspruch 1 oder 2, dadurch gekennzeichnet, daß die Dotierung des ersten Bereichs (3) von zu dem zweiten Bereich (2) entgegengesetzten Dotierungstyp ist.

4. Verfahren nach einem der vorangehenden Ansprüche, dadurch gekennzeichnet, daß der erste Bereich (3) eine Dotierung hoher Konzentration aufweist.

5. Verfahren nach einem der vorangehenden Ansprüche, dadurch gekennzeichnet, daß die Wärmebehandlung bei einer Temperatur von wenigstens 600° C durchgeführt wird.

6. Verfahren nach einem der vorangehenden Ansprüche, dadurch gekennzeichnet, daß die erste Metallschicht (6) aus einem anderen Material besteht als die zweite Metallschicht (8).

7. Verfahren nach einem der vorangehenden Ansprüche, dadurch gekennzeichnet, daß die erste Metallschicht (6) eine große Diffusionsgeschwindigkeit und die zweite Metallschicht (8) eine große Löslichkeit für Si-Atome aufweist.

8. Verfahren nach einem der vorangehenden Ansprüche, dadurch gekennzeichnet, daß die erste Metallschicht (6) aus Palladium und die zweite Metallschicht (8) aus Titan besteht.

9. Verfahren nach einem der vorangehenden Ansprüche, dadurch gekennzeichnet, daß die Wärmebehandlung gleichzeitig mit einer entprechenden Wärmebehandlung eines anderen Verfahrensschrittes bei der Herstellung des Halbleiterbauelements durchgeführt wird, insbesondere mit der Wärmebehandlung bei der Rückseitenmetallisierung des Bauelements.

10. Halbleiterbauelement mit einem Siliziumsubstrat, in dem ein erster Bereich (3) einer ersten Tiefe mit einer ersten Dotierung und ein zweiter Bereich (2) einer zweiten, größeren Tiefe mit einer zweiten Dotierung ausgebildet sind, wobei auf dem ersten Bereich (3) eine erste Metallschicht (6) aufgebracht ist, dadurch gekennzeichnet, daß auf einem Teilbereich der ersten Metallschicht (6) eine zweite Metallschicht (8) aufgebracht ist, und der Teilbereich der ersten Metallschicht (6) mit der zweiten Metallschicht (8) aufgrund einer Wärmebehandlung derart durch den ersten Bereich (3) in den zweiten Bereich (2) abgesenkt ist, daß über die erste und zweite Metallschicht (6, 8) ein Kontaktanschluß zu dem zweiten Bereich (2) und über einen nicht mit der zweiten Metallschicht (8) bedeckten Teilbereich der ersten Metallschicht (6) ein Kontaktanschluß zu dem ersten Bereich (3) gebildet ist.

11. Halbleiterbauelement nach Anspruch 10, dadurch gekennzeichnet, daß der erste Bereich (3) von einem ersten Dotierungstyp einer hohen Konzentration und der zweite Bereich (2) von dem entgegengesetzten Dotierungstyp mit einer niedrigen Konzentration ist.

12. Halbleiterbauelement nach Anspruch 11, dadurch gekennzeichnet, daß das Substrat (1) vom ersten Dotierungstyp mit niedriger Konzentration ist und mit dem ersten und zweiten Bereich (3, 2) und den Kontaktanschlüssen sowie einer oberhalb des zweiten Dotierungsbereichs angeordneten, von diesem isolierten Gateelektrode (7) einen DMOS-Transistor bildet.
